# FASCICULE DE BREVET EUROPEEN

(11) **EP 4 546 323 B1**
(45) Date de publication et mention de la délivrance du brevet: **08.07.2026**
(21) Numéro de dépôt: 24207829.3
(22) Date de dépôt: 21.10.2024
(51) Int. Cl.: G09G 3/32

(54) **DISPOSITIF D'AFFICHAGE ÉLECTRONIQUE AVEC ANTICRÉNELAGE**
ELEKTRONISCHE ANZEIGEVORRICHTUNG MIT ANTIALIASING
ELECTRONIC DISPLAY DEVICE WITH ANTIALIASING

(30) Priorité: 23.10.2023 FR 2311484
(43) Date de publication de la demande: 30.04.2025
(73) Titulaire: THALES, 92190 Meudon (FR)
(72) Inventeur: TORAILLE, Vincent, 33700 MERIGNAC (FR); JEULIN, Franck, 33700 MERIGNAC (FR)
(74) Mandataire: Atout PI Laplace

(56) Documents cités:
- US-A1- 2021 142 716
- US-A1- 2022 077 121
- US-A1- 2022 352 131
- US-A1- 2023 132 981

## Description

### Domaine de l'invention

L'invention concerne le domaine des écrans d'affichage, notamment pour l'aéronautique, mais pour aussi d'autres applications.

### Etat de la technique

Dans le domaine de l'aéronautique, les écrans d'affichage peuvent être placés dans le poste de commande d'un aéronef - avion ou hélicoptère - civil ou militaire. Ces écrans peuvent servir à la navigation, la cartographie, la visualisation de l'horizon artificiel, ou le roulage au sol, notamment, mais d'autres applications existent et sont envisageables. En dehors de l'aéronautique, ces écrans peuvent servir pour les téléphones portables, les tablettes, les ordinateurs, les télévisions, ou encore les écrans d'affichage dans les lieux publics.

Ces écrans sont souvent conçus avec la technologie LCD (écran à cristaux liquides). Un rétroéclairage est maintenu en permanence, récemment par des LEDs (diodes électroluminescentes) blanches et en fonction de l'orientation des cristaux liquides, la lumière est ponctuellement transmise ou non transmise. Ce sont donc les cristaux liquides qui définissent les pixels. Pour obtenir une coloration, trois cellules de cristaux liquides par pixels sont utilisées, et munies chacune, parallèlement au cristal liquide, d'un filtre coloré rouge, vert ou bleu, ce qui permet, en en allumant une ou plusieurs, d'obtenir la couleur souhaitée. Les LEDs de rétroéclairage, qui peuvent faire 2 à 3 mm de largeur, sont couramment mises sur le côté (dans une configuration qualifiée de « edge-lit »), avec un guide d'onde planaire par exemple en PMMA (poly méthacrylate de méthyle acrylique ou plexiglas), chargé dans son volume pour diffuser sur le plan. Les LEDs de rétroéclairage sont allumées en permanence.

Les technologies d'écran à cristaux liquides LCD, basées sur la transmission et l'occultation d'une lumière présente en permanence en arrière-plan, sont concurrencées par des technologies dans lesquelles de la lumière colorée est émise par des LED, qui sont allumées et éteintes pour produire l'image - on parle alors de pixels autoémissifs. Ainsi, par exemple, des écrans OLED, sans cristaux liquides et sans rétroéclairage permanent, connaissent un succès dans le domaine grand public, par exemple dans les smartphones - les pixels peuvent être de 150 µm par exemple. Les OLEDs ou LEDs organiques dont la dimension est de l'ordre de grandeur du pixel sont formées par superposition de plusieurs couches semi-conductrices organiques. Les micro-LEDS sont, elles, un peu plus petites (jusqu'à aussi peu que 50 µm de largeur, voire moins), et construites à l'aide d'un matériau inorganique, en premier lieu le nitrure de gallium. Trois OLEDs ou trois micro-LEDs, une de chaque couleur de base, rouge (environ 630 nm), vert (environ 570 nm) et bleu (environ 450 nm) sont souvent utilisées pour former un pixel.

Les OLEDs ou les micro-LEDs sont commandées par des circuits CMOS sur silicium ou par des transistors à couches minces TFT. Par ces circuits de commande, on leur transmet une commande en courant.

On envisage des micro-LEDs qui soient nativement de différentes couleurs, par ajustement de la nature et/ou de l'épaisseur des couches de semi-conducteur inorganique de l'empilement. On connait aussi des micro-LEDs et des OLEDs nativement bleues, efficaces énergétiquement, avec, pour modifier la couleur, un filtre coloré disposé au-dessus de la diode, éventuellement de type point quantique ou de type phosphore, pour générer, à partir du bleu, soit du vert soit du rouge en fonction de la taille du point quantique, dans les deux cas avec une largeur de raie également assez faible, à mi-pic de 20 à 30 nm.

L'anticrénelage est un ensemble de méthodes permettant d'éviter de remarquer la forme anguleuse des pixels. Des pixels plus ou moins gris ou plus ou moins colorés peuvent être positionnés pour créer des transitions douces à l'œil. Ces pixels, en ce qui concerne leur position, leur intensité lumineuse et leur couleur, peuvent être déterminés par interpolation ou lissage.

Les documents US2023/132981A1, US2022/352131A1, US2022/077121A1 et US2021/142716A1 font partie de l'état de l'art.

Il est proposé ici une nouvelle méthode d'anticrénelage, visant à obtenir une image douce en profitant des substrats de micro-LEDs qui sont maintenant disponibles. Ceux-ci sont obtenus par transfert de micro-LEDs d'un support de fabrication vers un substrat en verre dédié à l'écran, et seules les micro-LEDs dont on souhaite qu'elles soient transférées sont disposées sur le substrat de l'écran, avec le pas entre les micro-LEDs qui est souhaité pour la conception de l'écran.

Pour améliorer les techniques d'anticrénelage existantes, il est proposé un procédé d'affichage d'une image numérique matricielle comprenant d'une part la commande de groupes de trois éléments colorés, chaque élément étant d'une couleur différente, chaque groupe formant un élément ou pixel élémentaire d'une image en couleurs, et le procédé comprenant d'autre part un traitement anticrénelage de l'affichage.

Ce procédé est particulier car chaque élément coloré est un ensemble plan convexe de plusieurs diodes électroluminescentes, chacun desdits éléments dans un groupe étant recouvert d'une plaque commune auxdites diodes dudit élément et diffusant la lumière colorée associée audit élément, le traitement anticrénelage étant mené par application de commandes de différentes intensités lumineuses aux diodes à l'intérieur d'un même élément.

Grâce à cette technique, on met en place un anticrénelage à l'intérieur des pixels. Cela est particulièrement intéressant pour afficher des images vidéos enregistrée avec une résolution donnée, sur un écran constitué de micro-LEDs avec un pas plus fin que ce que la résolution de l'enregistrement permet de reproduire, et ainsi, on évite de consommer une puissance de calcul importante, alors que l'anticrénelage permet néanmoins d'avoir une image douce dans laquelle les angles des pixels ne sont pas visibles. On fait ainsi de l'atténuation locale (local dimming en anglais) à l'intérieur des pixels et à l'intérieur des ensembles d'une couleur donnée. Cela est très utile pour tracer des symboles fins. On améliore la finesse de l'anticrénelage, sans pour autant augmenter la résolution et donc le coût computationnel.

Les différentes intensités lumineuses à l'intérieur d'un élément constituent un gradient d'intensité.

L'ensemble plan convexe est un rectangle, et les différentes intensités lumineuses sont commandées par des gradients sur le premier côté et sur le deuxième côté du rectangle.

Selon des caractéristiques optionnelles et avantageuses: -les diodes électroluminescentes sont des diodes à base de nitrure de gallium, dites micro-LEDs.
- les diodes électroluminescentes sont des diodes bleues, les plaques communes étant verte, rouge, et peu colorée.
- les plaques communes comprennent des points quantiques de différentes tailles pour donner différentes couleurs.
- les éléments colorés sont allongés et disposés parallèlement les uns aux autres selon une direction transversale à la direction d'allongement.

Il est aussi proposé un dispositif d'affichage d'une image numérique matricielle comprenant des moyens de commande de groupes de trois éléments colorés du dispositif, chaque élément étant d'une couleur différente, chaque groupe formant un élément élémentaire d'une image en couleurs, et un moyen de traitement anticrénelage de l'affichage.

Ce dispositif d'affichage est particulier car chaque élément coloré est un ensemble plan convexe de plusieurs diodes électroluminescentes, chacun desdits éléments dans un groupe étant recouvert d'une plaque commune auxdites diodes dudit élément et diffusant la lumière colorée associée audit élément, le moyen de traitement anticrénelage appliquant des commandes de différentes intensités lumineuses aux diodes à l'intérieur d'un même élément.

### Brève description des dessins

L'invention sera mieux comprise et d'autres avantages apparaitront à la lecture de la description qui va suivre donnée à titre non limitatif et grâce aux figures annexées parmi lesquelles :
La figure 1 est une vue d'un agencement initial de micro-LEDs selon un mode de réalisation de l'invention.
La figure 2 est un schéma représentant un procédé selon l'invention.
La figure 3 est des vues d'un affichage selon l'invention.

### Description détaillée des dessins

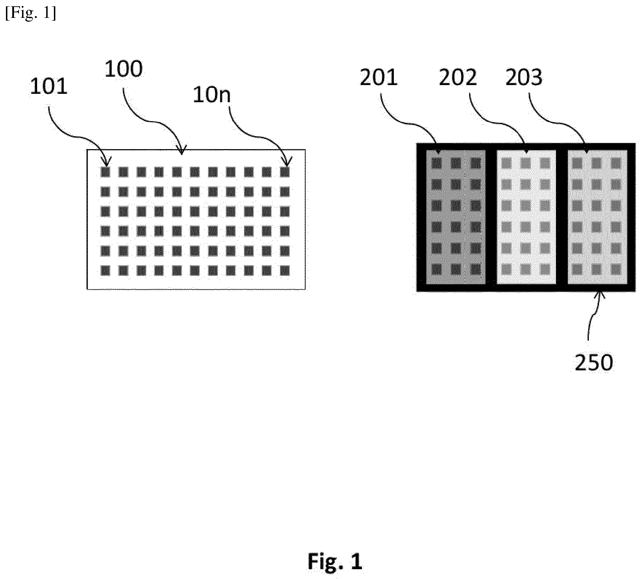

[Fig. 1] La FIGURE 1 montre un support 100, qui est un objet rigide ou semi-rigide plan à deux faces, d'épaisseur constante, portant des micro-LEDs 101, ... 10n disposées suivant un réseau à maille rectangulaire, ou un damier sur l'une de ses faces. Les micro-LEDs 101, ... 10n sont de géométrie carrée, vu de dessus. Elles sont séparées les unes des autres par une distance qui est du même ordre de grandeur que leur dimension. Elles sont, sur la figure, les micro-LEDs 101, ... 10n sont au nombre de 11 par 6, soit 66 micro-LEDs. Il s'agit de micro-LEDs bleues, connues pour leur bonne efficacité énergétique.

La figure 1 propose deux manières d'utiliser le support 100, en déposant sur la face qui porte les micro-LEDs, des plaques laissant passer de la lumière.

Dans une première réalisation, présentée en partie supérieure droite de la figure, des plaques 201, 202 et 203 rectangulaires sont choisis pour recouvrir 3x6 micro-LEDs et elles sont placés sur le support 100, les unes à côté des autres, séparés par un dépôt de matériau à forte densité optique (dit black matrix). Deux rangées de 6 micro-LEDs sont recouvertes, incidemment, par le matériau à forte densité optique.

La plaque 201 est un filtre coloré rouge à base de point quantique (même si des solutions moins sophistiquées sont possibles), la plaque 202 est un filtre coloré vert également à base de point quantique et la plaque 203 est un matériau diffusant passif qui est choisi pour que la diffusion angulaire des trois plaques 201, 202 et 203 soit la même. Il fournir donc une lumière bleue, à l'instar des micro-LEDs sous-jacentes.

L'ensemble des trois plaques 201-203 et des micro-LEDs qu'elles recouvrent constitue un pixel, puisque les trois couleurs formées permettent par combinaison d'obtenir toutes les couleurs du visible, et les 66 micro-LEDs sont donc commandées de manière à fournir la couleur et la luminosité voulue pour un pixel de cette taille, qui correspond à une résolution sous-optimale compte tenu de la petite taille des micro-LEDs, mais qui peut être tout à fait similaire à la résolution obtenue avec des technologies plus anciennes, comme les écrans à LCD et rétroéclairage.

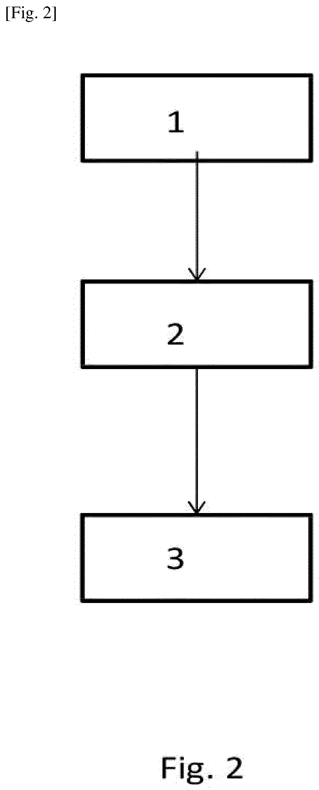

[Fig. 2] En figure 2, on a représenté le procédé selon l'invention. Au cours d'une étape 1, on établit quelle doit être la luminosité totale et la couleur d'un pixel, puis au cours d'une étape 2, on ajuste, pour chaque micro-LED du pixel, la luminosité, en tenant compte de la couleur associée au pixel, pour obtenir un ensemble du pixel qui soit de la bonne couleur et de la bonne luminosité, mais en plus qui garantisse la douceur de l'image, malgré sa pixellisation.

En étape 3, on procède à l'affichage adapté sur l'écran à pixels émissifs de la figure 1.

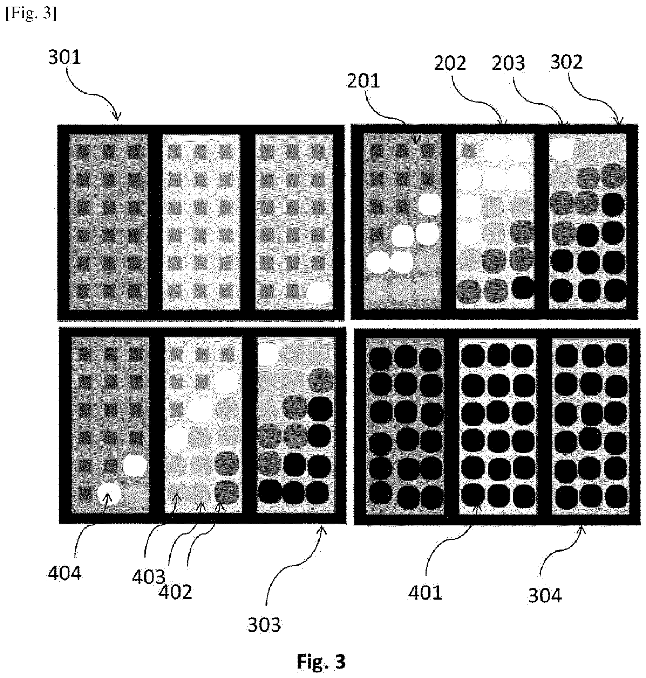

[Fig. 3] En figure 3, on a représenté un affichage sur l'écran de la figure 1, à l'issue de la méthode de la figure 2. Quatre pixels sont représentés, à savoir les pixels 301 et 302 sur une première ligne et les pixels 303 et 304 sur une deuxième ligne. Les pixels 301 et 303 sont dans une première colonne et les pixels 302 et 304 sont dans une deuxième colonne. Ils sont contigus les uns des autres. Ici, un symbole est affiché sur le pixel 304, qui est allumé en entier avec une forte luminance sur toutes les micro-LEDs de sa surface, dans ses trois éléments de couleur définis par des plaques colorés (référencés 202, 202 et 203 pour le pixel 302, chaque pixel étant sur ce point identique).

Les micro-LEDs 401 sont allumées avec une forte intensité, et les micro-LEDs 402 sont allumées avec une intensité moyenne dite moyenne élevée, les micro-LEDs 403 sont allumées avec une intensité moyenne dite moyenne faible, les micro-LEDs 404 sont allumées avec une intensité faible. Les autres micro-LEDs ne sont pas allumées. On a donc allumé toutes les micro-LEDs du pixel 304 avec une intensité élevée, et un gradient selon la direction des colonnes et un autre gradient selon la direction des lignes sont calculés et mis en œuvre pour allumer quelques diodes des pixels 303 et 302 à proximité de leurs frontières respectives avec le pixel 304 avec une forte intensité, puis en s'éloignant du pixel 304, une intensité moyenne élevée, puis une intensité moyenne faible, puis enfin une intensité faible.

On applique ainsi un anticrénelage fin, puisqu'il est basé sur une atténuation au sein des pixels, voire au sein des points de couleur de base. Le coût en terme de charge de calcul est particulièrement amélioré par rapport aux techniques qui constitueraient à gérer une résolution supérieure, pour définir la résolution au niveau des micro-LEDs individuelles, et non pas des pixels 301-304.

## Revendications

1. Procédé d'affichage d'une image numérique matricielle sur un écran à pixels émissifs comprenant la commande de groupes de trois éléments colorés (201, 202, 2023), chaque élément coloré étant d'une couleur différente, chaque groupe formant un pixel élémentaire (301-304) d'une image en couleurs, chaque élément coloré (201-203) est un ensemble plan convexe de plusieurs diodes électroluminescentes (101, ... 10n), chacun desdits éléments dans un groupe étant recouvert d'une plaque commune auxdites diodes dudit élément et diffusant la lumière colorée associée audit élément, l'ensemble plan convexe est un rectangle;
le procédé étant **caractérisé en ce que** la commande comprend un traitement anticrénelage de l'affichage mené, pour chaque élément, par application de commandes de différentes intensités lumineuses aux diodes électroluminescentes à l'intérieur d'un même élément, les différentes intensités lumineuses étant commandées par des gradients sur le premier côté et sur le deuxième côté du rectangle de façon à ce que les différentes intensités lumineuses à l'intérieur d'un élément constituent un gradient d'intensité selon la direction des colonnes et un autre gradient d'intensité selon la direction des lignes.

2. Procédé d'affichage d'une image numérique matricielle selon la revendication 1, **caractérisé en ce que** les diodes électroluminescentes sont des diodes à base de nitrure de gallium, dites micro-LEDs.

3. Procédé d'affichage d'une image numérique matricielle selon la revendications 1 ou la revendication 2, **caractérisé en ce que** les diodes électroluminescentes sont des diodes bleues, les plaques communes étant verte, rouge, et peu colorée.

4. Procédé d'affichage d'une image numérique matricielle selon l'une des revendications 1 à 43, **caractérisé en ce que** les plaques communes comprennent des points quantiques de différentes tailles pour donner différentes couleurs.

5. Procédé d'affichage d'une image numérique matricielle selon l'une des revendications 1 à 4, **caractérisé en ce que** les éléments colorés sont allongés et disposés parallèlement les uns aux autres selon une direction transversale à la direction d'allongement.

6. Dispositif d'affichage d'une image numérique matricielle comprenant un écran à pixels émissifs et des moyens de commande de groupes de trois éléments colorés de l'écran, chaque élément étant d'une couleur différente, chaque groupe formant un pixel élémentaire d'une image en couleurs, chaque élément coloré étant un ensemble plan convexe de plusieurs diodes électroluminescentes, chacun desdits éléments dans un groupe étant recouvert d'une plaque commune auxdites diodes dudit élément et diffusant la lumière colorée associée audit élément et dans lequel l'ensemble plan convexe est un rectangle; le dispositif étant caractérisé en ce les moyens de commande comprennent un moyen de traitement anticrénelage de l'affichage configuré afin d'appliquer, pour chaque élément, des commandes de différentes intensités lumineuses aux diodes à l'intérieur d'un même élément, les différentes intensités lumineuses étant commandées par des gradients sur le premier côté et sur le deuxième côté du rectangle de façon à ce que les différentes intensités lumineuses à l'intérieur d'un élément constituent un gradient d'intensité selon la direction des colonnes et un autre gradient d'intensité selon la direction des lignes.

## Patentansprüche

1. Verfahren zum Anzeigen eines digitalen Rasterbildes auf einem Bildschirm mit emissiven Pixeln, umfassend das Steuern von Gruppen aus drei farbigen Elementen (201, 202, 2023), wobei jedes farbige Element in einer anderen Farbe ist, wobei jede Gruppe ein elementares Pixel (301-304) eines Farbbildes bildet,
jedes farbige Element (201-203) eine plankonvexe Anordnung aus mehreren Leuchtdioden (101, ... 10n) ist, wobei jedes der Elemente in der Gruppe von einer den Dioden des Elements gemeinsamen Platte bedeckt ist, und das dem Element zugeordnete farbige Licht verbreitet, wobei die plankonvexe Anordnung ein Rechteck ist;
wobei das Verfahren **dadurch gekennzeichnet ist, dass** die Steuerung eine Antialiasing-Behandlung der geführten Anzeige für jedes Element durch Anwenden von Steuerungen verschiedener Leuchtstärken auf die Leuchtdioden im Inneren eines gleichen Elements umfasst, wobei die verschiedenen Leuchtstärken durch Gradienten auf der ersten Seite und auf der zweiten Seite des Rechtecks gesteuert werden, sodass die verschiedenen Leuchtstärken im Inneren eines Elements einen Intensitätsgradienten in der Richtung der Spalten, und einen anderen Intensitätsgradienten in der Richtung der Zeilen darstellen.

2. Verfahren zum Anzeigen eines digitalen Rasterbildes nach Anspruch 1, **dadurch gekennzeichnet, dass** die Leuchtdioden Dioden auf Basis von Galliumnitrid, sogenannte Mikro-LEDs sind.

3. Verfahren zum Anzeigen eines digitalen Rasterbildes nach Anspruch 1 oder Anspruch 2, **dadurch gekennzeichnet, dass** die Leuchtdioden blaue Dioden sind, wobei die gemeinsamen Platten grün, rot oder wenig gefärbt sind.

4. Verfahren zum Anzeigen eines digitalen Rasterbildes nach einem der Ansprüche 1 bis 3, **dadurch gekennzeichnet, dass** die gemeinsamen Platten Quantenpunkte in verschiedenen Größen umfassen, um verschiedene Farben zu ergeben.

5. Verfahren zum Anzeigen eines digitalen Rasterbildes nach einem der Ansprüche 1 bis 4, **dadurch gekennzeichnet, dass** die farbigen Elemente länglich, und in einer Richtung quer zur Längsrichtung parallel zueinander angeordnet sind.

6. Vorrichtung zum Anzeigen eines digitalen Rasterbildes, umfassend einen Bildschirm mit emissiven Pixeln und Mittel zum Steuern von Gruppen aus drei farbigen Elementen des Bildschirms, wobei jedes Element in einer anderen Farbe ist,
wobei jede Gruppe ein elementares Pixel eines Farbbildes bildet, jedes farbige Element eine plankonvexe Anordnung aus mehreren Leuchtdioden ist, wobei jedes der Elemente in der Gruppe von einer den Dioden des Elements gemeinsamen Platte bedeckt ist, und das dem Element zugeordnete farbige Licht verbreitet, wobei die plankonvexe Anordnung ein Rechteck ist; wobei die Vorrichtung **dadurch gekennzeichnet ist, dass** die Mittel zum Steuern ein Mittel zur Antialiasing-Behandlung der Anzeige umfassen, die konfiguriert ist, um für jedes Element Steuerungen verschiedener Leuchtstärken auf die Dioden im Inneren eines gleichen Elements anzuwenden, wobei die verschiedenen Leuchtstärken durch Gradienten auf der ersten Seite und auf der zweiten Seite des Rechtecks gesteuert werden, sodass die verschiedenen Leuchtstärken im Inneren eines Elements einen Intensitätsgradienten in der Richtung der Spalten, und einen anderen Intensitätsgradienten in der Richtung der Zeilen darstellen.

## Claims

1. A method for displaying a digital raster image on an emissive-pixel display comprising controlling groups of three colored elements (201, 202, 2023), each colored element being of a different color, each group forming an elementary pixel (301-304) of a color image,
each colored element (201-203) is a convex planar assembly of several light-emitting diodes (101, ... 10n), each of said elements in a group being covered by a plate common to said diodes of said element and diffusing the colored light associated with said element, the convex planar assembly being a rectangle;
the method being **characterized in that** the control comprises anti-aliasing processing of the display performed, for each element, by applying controls of different light intensities to the light-emitting diodes within a same element, the different light intensities being controlled by gradients on the first side and on the second side of the rectangle such that the different light intensities within an element form an intensity gradient in the direction of the columns and another intensity gradient in the direction of the rows.

2. The method for displaying a digital raster image according to claim 1, **characterized in that** the light-emitting diodes are gallium nitride-based diodes, known as micro-LEDs.

3. The method for displaying a digital raster image according to claim 1 or claim 2, **characterized in that** the light-emitting diodes are blue diodes, the common plates being green, red, and little colored.

4. The method for displaying a digital raster image according to any one of claims 1 to 3, **characterized in that** the common plates comprise quantum dots of different sizes to produce different colors.

5. The method for displaying a digital raster image according to one of claims 1 to 4, **characterized in that** the colored elements are elongated and disposed parallel to one another in a direction transverse to the direction of elongation.

6. A device for displaying a digital raster image comprising a screen with emissive pixels and means for controlling groups of three colored elements of the screen, each element being of a different color,
each group forming an elementary pixel of a color image, each colored element being a convex planar assembly of several light-emitting diodes, each of said elements in a group being covered by a plate common to said diodes of said element and diffusing the colored light associated with said element, and wherein the convex planar assembly is a rectangle; the device being **characterized in that** the control means comprise anti-aliasing processing means of the display configured in order to apply, for each element, controls of different light intensities to the diodes within a same element, the different light intensities being controlled by gradients on the first side and on the second side of the rectangle such that the different light intensities within an element form an intensity gradient in the direction of the columns and another intensity gradient in the direction of the rows.
